# EUROPEAN PATENT APPLICATION

(11) **EP 3 855 489 A1**
(43) Date of publication of application: **28.07.2021**
(21) Application number: 19861380.4
(22) Date of filing: 17.09.2019
(51) Int. Cl.: H01L 25/00, H01L 23/495

(54) **PACKAGE STRUCTURE AND STACKED PACKAGE STRUCTURE**

(30) Priority: 21.09.2018 CN 201811118363
(71) Applicant: NANJING ZTE NEW SOFTWARE CO., LTD., Nanjing, Jiangsu 210012 (CN)
(72) Inventor: LI, Hengjun, Shenzhen, Guangdong 518057 (CN); CHEN, Lixia, Shenzhen, Guangdong 518057 (CN); WANG, Linguo, Shenzhen, Guangdong 518057 (CN); ZHANG, Bin, Shenzhen, Guangdong 518057 (CN)
(74) Representative: Aipex B.V.
(86) International application number: PCT/CN2019/106103
(87) International publication number: WO 2020/057483

(57) **Abstract**

Provided are a package structure and a stacked package structure. The package structure includes a package body and an electrical connection portion. The package body is provided with a circuit carrier. The electrical connection portion is disposed outside the package body. The package structure further includes a conductive structure. The conductive structure is disposed on an outer surface of at least one side surface of the package body and is configured to electrically connect the circuit carrier and the electrical connection portion.

## Description

This application claims priority to Chinese Patent Application No. 201811118363.X filed on Sep. 21, 2018, disclosure of which is incorporated herein by reference in its entirety.

### TECHNICAL FIELD

Embodiments of the present application relate to the field of package technologies, for example, a package structure and a stacked package structure.

### BACKGROUND

A package structure refers to a structure formed by disposing multiple components on a substrate circuit carrier of a package body. However, since all components are mounted on the substrate circuit carrier, a larger area of the substrate circuit carrier board is occupied. In the case where the package structure is mounted on an external circuit substrate, a larger area of the external circuit substrate is also occupied.

In the related art, to reduce the area of the external circuit substrate and occupied by the package structure, a pad is usually disposed on a surface of the package body, and then, a conductive structure that electrically connects the pad to the substrate circuit carrier is disposed inside the package body, so that a part of the multiple components can be mounted on the pad.

However, in this solution, since the conductive structure that electrically connects the pad to the substrate circuit carrier is disposed inside the package body, a larger area of the substrate circuit carrier is occupied, thereby reducing the area of the substrate circuit carrier and for mounting the multiple components.

### SUMMARY

An embodiment of the present disclosure provides a package structure. The package structure includes a package body and an electrical connection portion. The package body is provided with a circuit carrier. The electrical connection portion is disposed outside the package body. The package structure further includes a conductive structure. The conductive structure is disposed on an outer surface of at least one side surface of the package body and is configured to electrically connect the circuit carrier and the electrical connection portion.

An embodiment of the present application further provides a stacked package structure. The stacked package structure includes a first component structure and the preceding package structure.

The first component structure is disposed on the electrical connection portion.

An embodiment of the present application further provides a stacked package structure. The stacked package structure includes a third component structure and the preceding package structure.

The third component structure is disposed on an upper surface of the circuit carrier.

An embodiment of the present application further provides a stacked package structure. The stacked package structure includes a fifth component structure and the preceding package structure.

The fifth component structure is disposed on an electrical connection portion on an upper surface of the package body.

The conductive structure on the at least one side surface of the package body is electrically connected to an external circuit substrate.

An embodiment of the present application further provides a stacked package structure. The stacked package structure includes a sixth component structure and the preceding package structure.

The sixth component structure is disposed on an electrical connection portion on the top of the package body.

### BRIEF DESCRIPTION OF DRAWINGS

FIG. 1 is a structural diagram of a package structure according to an embodiment of the present application;
FIG. 2 is a structural diagram of another package structure according to an embodiment of the present application;
FIG. 3 is a structural diagram of another package structure according to an embodiment of the present application;
FIG. 4 is a structural diagram of another package structure according to an embodiment of the present application;
FIG. 5 is a structural diagram of another package structure according to an embodiment of the present application;
FIG. 6 is a structural diagram of a stacked package structure according to an embodiment of the present application;
FIG. 7 is a structural diagram of another stacked package structure according to an embodiment of the present application;
FIG. 8 is a structural diagram of another stacked package structure according to an embodiment of the present application;
FIG. 9 is a structural diagram of another stacked package structure according to an embodiment of the present application;
FIG. 10 is a structural diagram of another stacked package structure according to an embodiment of the present application;
FIG. 11 is a structural diagram of another stacked package structure according to an embodiment of the present application;
FIG. 12 is a stereo view of a stacked package structure according to an embodiment of the present application;
FIG. 13 is a structural diagram of another stacked package structure according to an embodiment of the present application; and
FIG. 14 is a structural diagram of another stacked package structure according to an embodiment of the present application.

### DETAILED DESCRIPTION

In the related art, a conductive structure that electrically connects a pad to a substrate circuit carrier and is disposed inside a package body mainly includes an overhead metal frame, a copper pillar and a through mold via (TMV).

The overhead metal frame: An overhead folding frame is installed on the substrate circuit carrier, and the pad is formed on a surface of the package body after a plastic package to mount components. In this solution, the mounting of the metal frame occupies a certain area of the substrate circuit carrier, and a position where the metal frame is mounted on the substrate circuit carrier is a fixed position, so the layout of components on the substrate circuit carrier is limited, and no more pads can be provided. Additionally, the flatness of the frame mounting affects a surface pad, and also affects a plastic package process of the package body.

In the copper pillar, a copper pillar penetrating through the whole package body is disposed on the substrate circuit carrier, and the copper pillar penetrates the package body and provides the pad on the surface of the package body. In this solution, although the copper pillar occupies a relatively small area of the substrate circuit carrier, a surface mount pad that can be provided also has a small area. Moreover, the number of copper pillars cannot be too large, and otherwise, a large area of the substrate circuit carrier is occupied.

In the TMV, a via is formed by laser drilling and filled with conductive media, such as solder paste and silver paste, so as to provide the pads. Solders and silver paste on the surface of the package body implements the electrical interconnection between a substrate circuit and surface mount components of the package body. In this solution, through mold vias occupy a large surface mount area of the substrate circuit carrier, and pads provided by the solders, the silver paste and the like easily lead to rosin joints, thereby having low reliability.

An embodiment of the present application provides a package structure. The package structure includes a package body and an electrical connection portion. The package body is provided with a circuit carrier. The electrical connection portion is disposed outside the package body. The package structure further includes a conductive structure.

The conductive structure is disposed on an outer surface of at least one side surface of the package body and is configured to electrically connect the circuit carrier and the electrical connection portion.

In an embodiment, the electrical connection includes, but is not limited to, a metal pad. The conductive structure includes, but is not limited to, a conductive surface. The material of the conductive surface includes, but is not limited to, metal and nonmetal having a conductive function, such as an alloy. In the case where the material of the conductive surface is metal, the conductive surface may be, but is not necessarily, formed by sputtering, electroplating, electroless deposition, physical vapor deposition (PVD), end electroplating, sintering or the like.

In an embodiment, the circuit carrier may be electrically connected to the conductive structure on the outer surface of the at least one side surface of the package body via a metal connection wire of the circuit carrier. That is, the metal connection wire on a side surface of the circuit carrier can penetrate through the package body and reach the outside of the package body, so the circuit carrier can be electrically interconnected to the conductive structure.

The package material of the package body includes, but is not limited to, epoxy molding compound (EMC), prepreg formed of epoxy resin and glass fiber, Ajinomoto build-up films (ABF) glue, ceramics and other materials.

The circuit carrier includes, but is not limited to, an organic printed circuit board, a ceramic substrate, a lead frame substrate and other circuit carriers having functions of component mounting, electrical interconnection and mechanical support. At least one component is provided on the circuit carrier. The at least one component includes, but is not limited to, an active component, a passive component and other components. The active component may be packaged in the form of a die, or a packaged quad flat no-lead package (QFN), a ball grid array (BGA) package, a chip scale package (CSP), a wafer level chip scale packaging (WLCSP). A component in the package body is electrically interconnected to the circuit carrier by interconnecting processes such as, but not limited to, surface mount technology (SMT), a flip chip (FC) and wire bonding (WB).

In the package structure provided by the embodiment of the present application, the conductive structure for electrically connecting the circuit carrier and the electrical connection portion is disposed on the at least one side surface of the package body, so that the circuit carrier is no longer occupied, thereby avoiding reducing the area of the substrate circuit carrier and for mounting components.

In an embodiment, the bottom of the package body is a circuit carrier.

The electrical connection portion is disposed on the top of the package body.

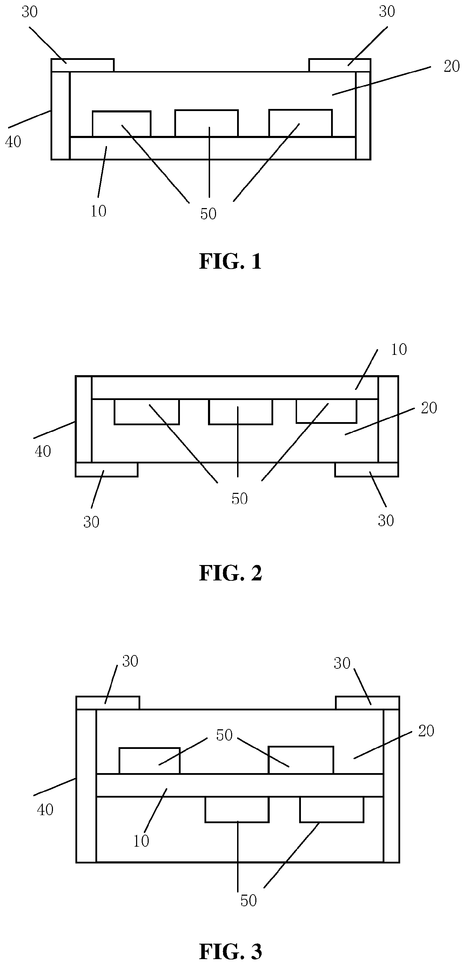

FIG. 1 is a schematic diagram of a package structure according to an embodiment of the present application. As shown in FIG. 1, the package structure provided by this embodiment of the present application includes a package body 20 and an electrical connection portion 30. The package body 20 is provided with a circuit carrier 10. The package structure further includes a conductive structure 40. In the package body 20, multiple components 50 are provided, the circuit carrier 10 serves as the bottom of the package body 20, the multiple components 50 are disposed on the circuit carrier 10, the electrical connection portion 30 is disposed on the top of the package body 20, and the conductive structure 40 is disposed on an outer surface of the left side surface of the package body 20 and is configured to electrically connect the circuit carrier 10 and the electrical connection portion 30.

In an embodiment, the top of the package body is the circuit carrier, and the electrical connection portion is disposed on the bottom of the package body.

FIG. 2 is a schematic diagram of another package structure according to an embodiment of the present application. As shown in FIG. 2, the package structure provided by this embodiment of the present application includes a package body 20 and an electrical connection portion 30. The package body 20 is provided with a circuit carrier 10. The package structure further includes a conductive structure 40. In the package body 20, multiple components 50 are provided, the circuit carrier 10 serves as the top of the package body 20, the multiple components 50 are disposed on the circuit carrier 10, the electrical connection portion 30 is disposed on the bottom of the package body 20, and the conductive structure 40 is disposed on an outer surface of the left side surface of the package body 20 and is configured to electrically connect the circuit carrier 10 and the electrical connection portion 30.

In an embodiment, both the distance between the circuit carrier and the top of the package body and the distance between the circuit carrier and the bottom of the package body are greater than preset distances. That is, the distance between the circuit carrier and the top of the package body is greater than a respective preset distance, and the distance between the circuit carrier and the bottom of the package body is greater than a respective preset distance. In an embodiment, the distance between the circuit carrier and the top of the package body is greater than a first preset distance. In an embodiment, the distance between the circuit carrier and the bottom of the package body is greater than a second preset distance.

In an embodiment, the electrical connection portion is disposed on the top of the package body or on the bottom of the package body.

Both the distance between the circuit carrier and the top of the package body and the distance between the circuit carrier and the bottom of the package body are greater than preset distances, so that both sides of the circuit carrier can be mounted with components. That is, a position where the circuit carrier is located in the package body can merely enable both sides of the circuit carrier to be mounted with components.

FIG. 3 is a structural diagram of another package structure according to an embodiment of the present application. As shown in FIG. 3, the package structure provided by this embodiment of the present application includes a package body 20 and an electrical connection portion 30. The package body 20 is provided with a circuit carrier 10. The package structure further includes a conductive structure 40. Multiple components 50 are provided in the package body 20. The circuit carrier 10 is located inside the package body 20 and at certain distances from both the top of the package body 20 and the bottom of the package body 20. Both sides of the circuit carrier 10 are mounted with components 50. The electrical connection portion 30 is disposed on the top of the package body 20. The conductive structure 40 is disposed on an outer surface of the left side surface of the package body 20 and is configured to electrically connect the circuit carrier 10 and the electrical connection portion 30.

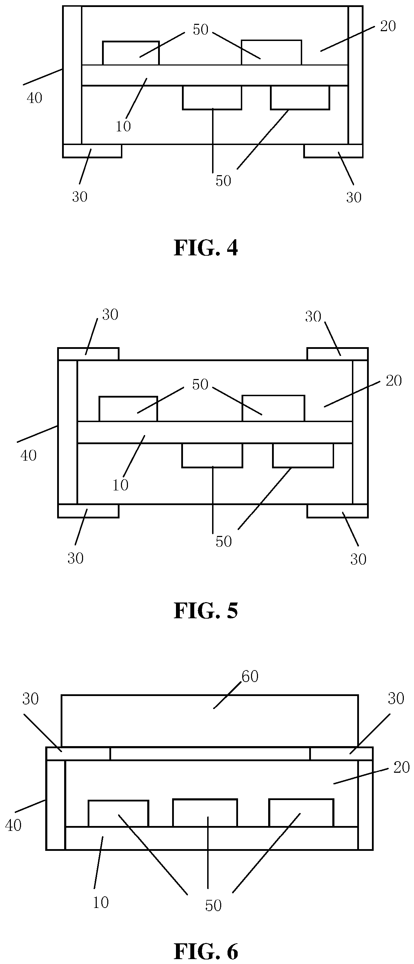

FIG. 4 is a structural diagram of another package structure according to an embodiment of the present application. As shown in FIG. 4, the package structure provided by this embodiment of the present application includes a package body 20 and an electrical connection portion 30. The package body 20 is provided with a circuit carrier 10. The package structure further includes a conductive structure 40. Multiple components 50 are provided in the package body 20. The circuit carrier 10 is located inside the package body 20 and at certain distances from both the top of the package body 20 and the bottom of the package body 20. Both sides of the circuit carrier 10 are mounted with components 50. The electrical connection portion 30 is disposed on the bottom of the package body 20. The conductive structure 40 is disposed on an outer surface of the left side surface of the package body and is configured to electrically connect the circuit carrier 10 and the electrical connection portion 30.

In an embodiment, electrical connection portions can be disposed on the top of the package body and on the bottom of the package body. That is to say, there are multiple electrical connection portions, and the multiple electrical connection portions are disposed on the top of the package body and on the bottom of the package body. For example, the electrical connection portions include a first electrical connection portion and a second electrical connection portion, where the first electrical connection portion is disposed on the top of the package body, and the second electrical connection portion is disposed on the bottom of the package body.

FIG. 5 is a structural diagram of another package structure according to an embodiment of the present application. As shown in FIG. 5, the package structure provided by this embodiment of the present application includes a package body 20 and an electrical connection portion 30. The package body 20 is provided with a circuit carrier 10. The package structure further includes a conductive structure 40. Multiple components 50 are provided in the package body 20. The circuit carrier 10 is located inside the package body 20 and at certain distances from both the top of the package body 20 and the bottom of the package body 20. Both sides of the circuit carrier 10 are mounted with components 50. Electrical connection portions 30 are disposed on the top of the package body 20 and on the bottom of the package body 20. The conductive structure 40 is disposed on an outer surface of the left side surface of the package body 20 and is configured to electrically connect the circuit carrier 10 and the electrical connection portion 30.

An embodiment of the present application provides a stacked package structure. The stacked package structure includes a first component structure and a package structure. The package structure includes a package body and an electrical connection portion. The package body is provided with a circuit carrier. The electrical connection portion is disposed outside the package body. The package structure further includes a conductive structure. The conductive structure is disposed on an outer surface of at least one side surface of the package body and is configured to electrically connect the circuit carrier and the electrical connection portion.

In an embodiment, the bottom of the package body is the circuit carrier.

In an embodiment, the electrical connection portion is disposed on the top of the package body.

In an embodiment, the first component structure is disposed on the electrical connection portion.

FIG. 6 is a structural diagram of a stacked package structure according to an embodiment of the present application. As shown in FIG. 6, the stacked package structure provided by this embodiment of the present application includes a first component structure 60 and a package structure. The package structure includes a package body 20 and an electrical connection portion 30. The package body 20 is provided with a circuit carrier 10. The package structure further includes a conductive structure 40. Multiple components 50 are provided in the package body 20. The circuit carrier 10 serves as the bottom of the package body 20. The multiple components 50 are disposed on the circuit carrier 10. The electrical connection portion 30 is disposed on the top of the package body 20. The conductive structure 40 is disposed on an outer surface of the left side surface of the package body 20 and is configured to electrically connect the circuit carrier 10 and the electrical connection portion 30. The first component structure 60 is disposed on the electrical connection portion 30.

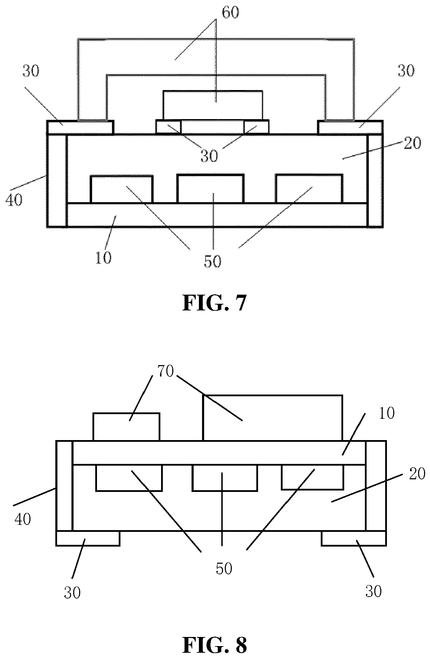

FIG. 7 is a structural diagram of another stacked package structure according to an embodiment of the present application. As shown in FIG. 7, on the stacked package structure shown in FIG. 6, the first component structure of the stacked package structure provided by this embodiment of the present application may further include an overhead component.

In an embodiment, the conductive structure on the at least one side surface of the package body is electrically connected to an external circuit substrate.

In an embodiment, the stacked package structure provided by this embodiment of the present application further includes a second component structure. The second component structure is disposed on a lower surface of the circuit carrier 10.

In an embodiment, the first component structure includes at least one component. In an embodiment, the second component structure includes at least one component.

The first component structure may be a first package body composed of multiple components. The second component structure may be a second package body composed of multiple components.

In an embodiment, the circuit carrier is electrically connected to an external circuit substrate.

An embodiment of the present application provides a stacked package structure. The stacked package structure includes a third component structure and a package structure. The package structure includes a package body and an electrical connection portion. The package body is provided with a circuit carrier. The electrical connection portion is disposed outside the package body. The package structure further includes a conductive structure. The conductive structure is disposed on an outer surface of at least one side surface of the package body and is configured to electrically connect the circuit carrier and the electrical connection portion.

In an embodiment, the top of the package body is the circuit carrier.

In an embodiment, the electrical connection portion is disposed on the bottom of the package body.

In an embodiment, the third component structure is disposed on an upper surface of the electrical connection portion.

FIG. 8 is a structural diagram of another stacked package structure according to an embodiment of the present application. As shown in FIG. 8, the stacked package structure provided by this embodiment of the present application includes a third component structure 70 and a package structure. The package structure includes a package body 20 and an electrical connection portion 30. The package body 20 is provided with a circuit carrier 10. The package structure further includes a conductive structure 40. Multiple components 50 are provided in the package body 20. The circuit carrier 10 serves as the top of the package body 20. The multiple components 50 are disposed on the circuit carrier 10. The electrical connection portion 30 is disposed on the bottom of the package body 20. The conductive structure 40 is disposed on an outer surface of the left side surface of the package body 20 and is configured to electrically connect the circuit carrier 10 and the electrical connection portion 30. The third component structure 70 is disposed on an upper surface of the circuit carrier 10.

According to the stacked package structure provided by this embodiment of the present application, the circuit carrier 10 is configured to carry the third component structure 70, so that dense circuits of the circuit carrier can be fully utilized to mount more components or more inputs/outputs (I/Os), and meanwhile, interconnection paths between internal circuits of the package body can be shortened to improve the circuit performance.

In an embodiment, the conductive structure on the at least one side surface of the package body is electrically connected to an external circuit substrate.

In an embodiment, the stacked package structure provided by this embodiment of the present application further includes a fourth component structure. The fourth component structure is disposed on the electrical connection portion 30.

In an embodiment, the third component structure includes at least one component. In an embodiment, the fourth component structure includes at least one component.

In an embodiment, the electrical connection portion is electrically connected to an external circuit substrate.

An embodiment of the present application provides a stacked package structure. The stacked package structure includes a fifth component structure and a package structure. The package structure includes a package body and an electrical connection portion. The package body is provided with a circuit carrier. The electrical connection portion is disposed outside the package body. The package structure further includes a conductive structure. The conductive structure is disposed on an outer surface of at least one side surface of the package body and is configured to electrically connect the circuit carrier and the electrical connection portion.

The distance between the circuit carrier and the top of the package body is greater than a respective preset distance, and the distance between the circuit carrier and the bottom of the package body is greater than a respective preset distance. In an embodiment, the distance between the circuit carrier and the top of the package body is greater than a first preset distance. In an embodiment, the distance between the circuit carrier and the bottom of the package body is greater than a second preset distance.

In an embodiment, the electrical connection portion is disposed on the top of the package body or on the bottom of the package body.

In an embodiment, the fifth component structure is disposed on the electrical connection portion.

In an embodiment, the conductive structure on the at least one side surface of the package body is electrically connected to an external circuit substrate.

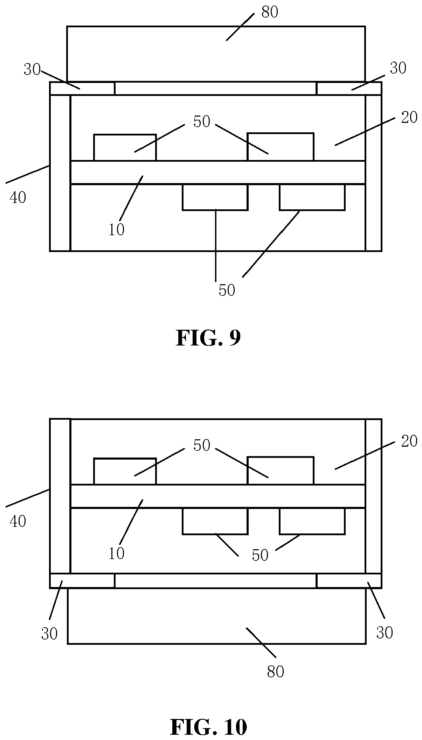

FIG. 9 is a structural diagram of another stacked package structure according to an embodiment of the present application. As shown in FIG. 9, the stacked package structure provided by this embodiment of the present application includes a fifth component structure 80 and a package structure. The package structure includes a package body 20 and an electrical connection portion 30. The package body 20 is provided with a circuit carrier 10. The package structure further includes a conductive structure 40. Multiple components 50 are provided in the package body 20. The circuit carrier 10 is located inside the package body 20 and at certain distances from both the top of the package body 20 and the bottom of the package body 20. Both sides of the circuit carrier 10 are mounted with components 50. The electrical connection portion 30 is disposed on the top of the package body 20. The conductive structure 40 is disposed on an outer surface of the left side surface of the package body 20 and is configured to electrically connect the circuit carrier 10 and the electrical connection portion 30. The fifth component structure 80 is disposed on the electrical connection portion 30 (that is, on the electrical connection portion 30 on the top of the package body).

FIG. 10 is a structural diagram of another stacked package structure according to an embodiment of the present application. As shown in FIG. 10, the stacked package structure provided by this embodiment of the present application includes a fifth component structure 80 and a package structure. The package structure includes a package body 20 and an electrical connection portion 30. The package body 20 is provided with a circuit carrier 10. The package structure further includes a conductive structure 40. Multiple components 50 are provided in the package body 20. The circuit carrier 10 is located inside the package body 20 and at certain distances from both the top of the package body 20 and the bottom of the package body 20. Both sides of the circuit carrier 10 are mounted with components 50. The electrical connection portion 30 is disposed on the bottom of the package body 20. The conductive structure 40 is disposed on an outer surface of the left side surface of the package body 20 and is configured to electrically connect the circuit carrier 10 and the electrical connection portion 30. The fifth component structure 80 is disposed on the electrical connection portion 30 (that is, on the electrical connection portion 30 on the bottom of the package body).

An embodiment of the present application provides another stacked package structure. The stacked package structure includes a sixth component structure and a package structure. The package structure includes a package body and an electrical connection portion. The package body is provided with a circuit carrier. The electrical connection portion is disposed outside the package body. The package structure further includes a conductive structure. The conductive structure is disposed on an outer surface of at least one side surface of the package body and is configured to electrically connect the circuit carrier and the electrical connection portion.

In an embodiment, both the distance between the circuit carrier and the top of the package body and the distance between the circuit carrier and the bottom of the package body are greater than preset distances. That is, the distance between the circuit carrier and the top of the package body is greater than a respective preset distance, and the distance between the circuit carrier and the bottom of the package body is greater than a respective preset distance. In an embodiment, the distance between the circuit carrier and the top of the package body is greater than a first preset distance. In an embodiment, the distance between the circuit carrier and the bottom of the package body is greater than a second preset distance.

In an embodiment, electrical connection portions are disposed on the top of the package body and on the bottom of the package body.

In an embodiment, the sixth component structure is disposed on an electrical connection portion on the top of the package body.

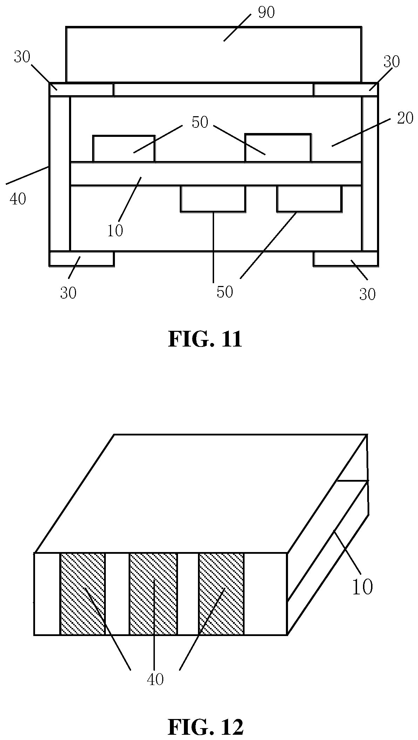

FIG. 11 is a structural diagram of another stacked package structure according to an embodiment of the present application. As shown in FIG. 11, the stacked package structure provided by this embodiment of the present application includes a sixth component structure 90 and a package structure. The package structure includes a package body 20 and an electrical connection portion 30. The package body 20 is provided with a circuit carrier 10. The package structure further includes a conductive structure 40. Multiple components 50 are included in the package body 20. The circuit carrier 10 is located inside the package body 20 and at certain distances from both the top of the package body 20 and the bottom of the package body 20. Both sides of the circuit carrier 10 are mounted with components 50. Electrical connection portions 30 are disposed on the bottom of the package body 20 and on the top of the package body 20. The conductive structure 40 is disposed on an outer surface of the left side surface of the package body 20 and is configured to electrically connect the circuit carrier 10 and the electrical connection portion 30. The sixth component structure 90 is disposed on an electrical connection portion 30 on the top of the package body 20.

In an embodiment, the conductive structure on the at least one side surface of the package body is electrically connected to an external circuit substrate.

FIG. 12 is a stereo view of a stacked package structure according to an embodiment of the present application. In FIG. 12, an electrical connection portion 30, components 50 and a sixth component structure 90 are omitted. As shown in FIG. 12, the stacked package structure may be electrically connected to an external circuit board via a conductive structure 40 on a side surface of a package body. In one aspect, the structure can occupy a smaller area of the external circuit substrate and dissipate heat on both sides. In another aspect, more electrical connection portions can further be disposed on the top of the package body and on the bottom of the package body.

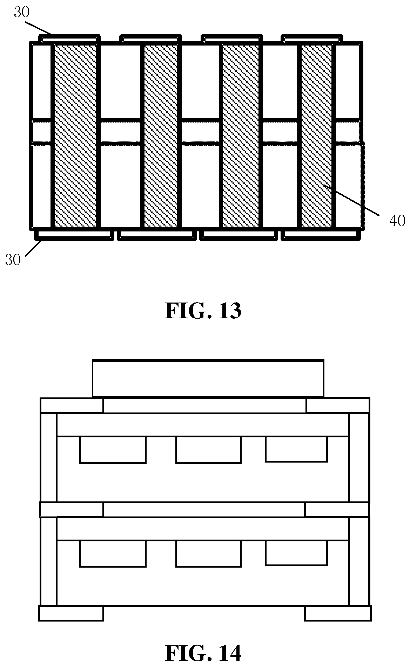

FIG. 13 is a structural diagram of another stacked package structure according to an embodiment of the present application. This embodiment is a structural diagram shown from a side surface of the package body. As shown in FIG. 13, both the top of the package body and the bottom of the package body are provided with electrical connection portions 30 for mounting electric component structures.

In an embodiment, the stacked package structure provided by this embodiment of the present application further includes a seventh component structure. The seventh component structure is disposed on an electrical connection portion on the bottom of the package body.

In an embodiment, the sixth component structure includes at least one component. In an embodiment, the seventh component structure includes at least one component.

In an embodiment, the electrical connection portion on the bottom of the package body is electrically connected to an external circuit substrate.

The stacked package structure provided by this embodiment of the application can make the component structure stacked on the package body, thereby making full use of the Z-direction space and reducing the size of a module. Additionally, the space of a side wall is used as an interconnection conductive layer, which not only reduces the occupied area of the external circuit substrate, but also provides a larger surface mount area for components inside the package body, and can further dissipate heat by using the conductive structure on the side surface. Compared with other stacked electronic package structures, the embodiments of the present application have the advantages that the Z-direction interconnection does not occupy the surface mount space of the package body, leading to freer wiring and component layout, and that the conductive structure on the side surface helps heat dissipation and electromagnetic shielding.

The stacked package structure provided by an embodiment of the present application may include two or more package structures. FIG. 14 is a schematic diagram of another stacked package structure according to an embodiment of the present application. As shown in FIG. 14, the stacked package structure includes two package structures.

## Claims

1. A package structure, comprising: a package body and an electrical connection portion, wherein the package body is provided with a circuit carrier, and the electrical connection portion is disposed outside the package body; and
the package structure further comprises a conductive structure, the conductive structure is disposed on an outer surface of at least one side surface of the package body and is configured to electrically connect the circuit carrier and the electrical connection portion.

2. The package structure of claim 1, wherein a bottom of the package body is the circuit carrier, and the electrical connection portion is disposed on a top of the package body.

3. The package structure of claim 1, wherein a top of the package body is the circuit carrier, and the electrical connection portion is disposed on a bottom of the package body.

4. The package structure of claim 1, wherein a distance between the circuit carrier and a top of the package body is greater than a respective preset distance, and a distance between the circuit carrier and a bottom of the package body is greater than a respective preset distance.

5. The package structure of claim 4, wherein the electrical connection portion is disposed on the top of the package body or the bottom of the package body.

6. The package structure of claim 4, wherein a plurality of electrical connection portions are provided, and the plurality of electrical connection portions are disposed on the top of the package body and on the bottom of the package body respectively.

7. A stacked package structure, comprising: a first component structure and the package structure of claim 2,
wherein the first component structure is disposed on the electrical connection portion.

8. The stacked package structure of claim 7, wherein the conductive structure on the at least one side surface of the package body is electrically connected to an external circuit substrate.

9. The stacked package structure of claim 8, further comprising: a second component structure, wherein the second component structure is disposed on a lower surface of the circuit carrier.

10. The stacked package structure of claim 9, wherein the first component structure comprises at least one component, and the second component structure comprises at least one component.

11. The stacked package structure of claim 7, wherein the circuit carrier is electrically connected to an external circuit substrate.

12. A stacked package structure, comprising: a third component structure and the package structure of claim 3,
wherein the third component structure is disposed on an upper surface of the circuit carrier.

13. The stacked package structure of claim 12, wherein the conductive structure on the at least one side surface of the package body is electrically connected to an external circuit substrate.

14. The stacked package structure of claim 13, further comprising: a fourth component structure,
wherein the fourth component structure is disposed on the electrical connection portion.

15. The stacked package structure of claim 14, wherein the third component structure comprises at least one component, and the fourth component structure comprises at least one component.

16. The stacked package structure of any one of claims 12 to 15, wherein the electrical connection portion is electrically connected to an external circuit substrate.

17. A stacked package structure, comprising: a fifth component structure and the package structure of claim 5,
wherein the fifth component structure is disposed on the electrical connection portion; and
wherein the conductive structure on the at least one side surface of the package body is electrically connected to an external circuit substrate.

18. A stacked package structure, comprising: a sixth component structure and the package structure of claim 6,
wherein the sixth component structure is disposed on an electrical connection portion on the top of the package body.

19. The stacked package structure of claim 18, wherein the conductive structure on the at least one side surface of the package body is electrically connected to an external circuit substrate.

20. The stacked package structure of claim 19, further comprising: a seventh component structure,
wherein the seventh component structure is disposed on an electrical connection portion on the bottom of the package body.

21. The stacked package structure of claim 20, wherein the sixth component structure comprises at least one component, and the seventh component structure comprises at least one component.

22. The stacked package structure of any one of claims 18 to 21, wherein an electrical connection portion on the bottom of the package body is electrically connected to an external circuit substrate.
